# EUROPEAN PATENT APPLICATION

(11) **EP 4 848 508 A1**
(43) Date of publication of application: **02.12.2026**
(21) Application number: 25179113.3
(22) Date of filing: 27.05.2025
(51) Int. Cl.: H02H 3/30, H02H 3/28, G01R 31/08, H02H 3/027

(54) **A DIFFERENTIAL PROTECTION METHOD**

(71) Applicant: Hitachi Energy Ltd, 8050 Zürich (CH)
(72) Inventor: Wang, Jianping, 724 60 Västerås (SE); Tajdinian, Mohsen, 723 46 Västerås (SE); Gore, Rahul, 128 34 Stockholm (SE); Hoq, Md Tanbhir, 722 46 Västerås (SE); Li, YouYi, 722 19 Västerås (SE)
(74) Representative: AWA Sweden AB

(57) **Abstract**

The present disclosure relates to a differential protection method for a protected multi-phase power transmission line, the method comprising:
- determining first local current phasors for the phases for a local end of the power transmission line and first remote current phasors for a remote end of the power transmission line;
- determining local incremental current phasors and remote incremental current phasors;
for each phase:
- determining a local polarized current phase angle as a difference between phase angles of the local incremental phase current and a local prefault phase current, and determining a corresponding remote polarized current phase angle;
- determining a differential current based on a current difference between a second local current phasor and a second remote current phasor, wherein the second local current phasor is consisting of an amplitude of the first local current phasor and the local polarized current phase angle, and the second remote current phasor is correspondingly composed; and
- determining a restraint current based on a maximum of the absolute values of the amplitudes of the first local and first remote current phasors, respectively;

- determining that a fault condition is true if, for at least one phase, the absolute value of the amplitude of the differential current is greater than the restraint current and greater than a pickup setup; and
- when the fault condition is true, setting a timeout, checking, when the timeout has expired, if the fault condition is still true, and generating, if affirmative, a trip signal.

## Description

### TECHNICAL FIELD

The present disclosure relates to a differential protection method for a protected multi-phase power transmission line.

### BACKGROUND

In power transmission systems, line differential protection has been used for transmission line protection applications as one of main protection solutions. The principle of line differential protection is based on Kirchhoff's Current Law (KCL) in which for external faults or normal load, differential currents calculated within the line is zero and for internal faults, the differential current is a higher value which is the summation of all source currents feeding to the fault point. The methods use local and remote current measurements, where the remote current measurements are sent via a communication link to the local site. Existing current line differential protections are based on strict time synchronization methods such as GPS synchronization or the ping-pong, or echo method, principle. It can only tolerate limited time synchronization errors. As one of example, the ping-pong solution requires symmetrical communication channels with the same transmission speed, i.e. the same time delays. For instance, a typical demand is that the unsymmetric time difference of sending channel and receiving channel on the communication link should be less than 0.1 millisecond.

In many power transmission networks, such as, typically, MV networks, there is no sophisticated communication link which can fulfil such as strong synchronization demand with a high enough operational reliability. Therefore, it is desirable to find other differential protection solutions which can permit certain time delays errors.

### SUMMARY

The present disclosure seeks to, at least partly, remedy the above discussed issues. To achieve this, a differential protection method, as defined by the independent claim, is provided. Embodiments thereof are provided in the dependent claims.
According to an aspect of the present disclosure, there is provided a differential protection method for a protected multi-phase power transmission line, comprising:
- determining first local current phasors for the phases from local end phase currents measured at a local end of the power transmission line;
- determining first remote current phasors for the phases from remote phase currents measured at a remote end of the power transmission line;
- determining local incremental current phasors for the phases from the local phase currents;
- determining remote incremental current phasors for the phases from the remote phase currents;
   for each phase:
   - determining a local polarized current phase angle as a difference between a phase angle of the local incremental phase current and a phase angle of a local prefault phase current, and determining a remote polarized current phase angle as a difference between a phase angle of the remote incremental phase current and a phase angle of a remote prefault phase current;
   - determining a differential current based on a current difference between a second local current phasor and a second remote current phasor, wherein the second local current phasor is consisting of an amplitude of the first local current phasor and the local polarized current phase angle, and wherein the second remote current phasor is consisting of an amplitude of the first remote current phasor and the remote polarized current phase angle; and
   - determining a restraint current based on a maximum of the absolute values of the amplitude of the first local current phasor and the amplitude of the first remote current phasor;
   - determining that a fault condition is true if, for at least one of the phases, the absolute value of the amplitude of the differential current is greater than the restraint current and greater than a pickup setup; and
when the fault condition is true, setting a timeout, checking, when the timeout has expired, if the fault condition is still true, and generating, if affirmative, a trip signal.

By means of the present method the problem of synchronization errors causing false tripping is decreased.

According to an embodiment of the method the timeout is greater than a maximum synchronization error time plus a time margin.

According to an embodiment the method comprises determining, before the operation of checking, for each phase, a phase angle index as a cosine of an absolute value of a difference between the local polarized current phase angle and the remote polarized current phase angle, and, if the phase angle index is greater than a threshold, setting the amplitude of the differential current zero.

According to an embodiment the method comprises, before performing the operations for each phase, detecting an occurrence of a fault including comparing at least one of the incremental currents with a fault threshold and deciding that a fault has occurred when one of the incremental currents exceeds the fault threshold.

According to an embodiment of the method each of the incremental currents is determined by means of an instantaneous value of the current, a value from one fundamental power frequency time period earlier and a value from two fundamental power frequency time periods earlier.

According to an embodiment the method comprises receiving, at a local intelligent electronic device, values of the remote incremental phase currents via a communication link.

According to an embodiment of the method the remote incremental phase currents have been polarized before being provided to the communication link.

According to an embodiment of the method the restraint current is determined, for each phase, as a fraction of the maximum of the first local current phasor and the first remote current phasor.

### BRIEF DESCRIPTION OF THE DRAWINGS

This and other aspects of the present disclosure will now be described in more detail, with reference to the appended drawings showing embodiments of the disclosure.
Figure 1 illustrates a power transmission system;
Figures 2 and 3 illustrate phase angle relations before and during a fault; and
Figure 4 is a flow chart of an embodiment of the differential protection method according to the present disclosure.

### DETAILED DESCRIPTION

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein; rather, these embodiments are provided for thoroughness and completeness, and fully convey the scope of the disclosure to the skilled person.

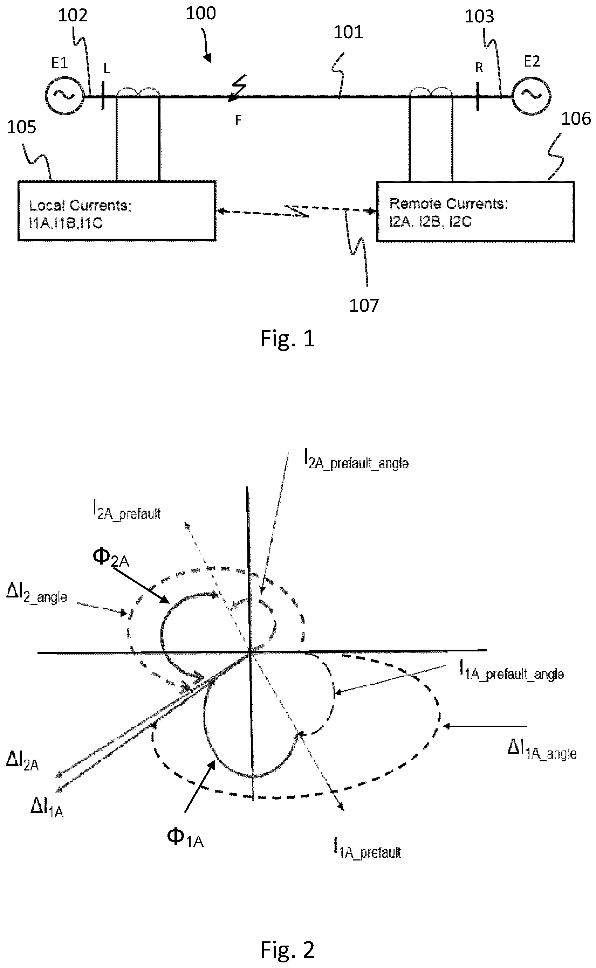

Fig. 1 shows a general model of an AC (Alternating Current) power transmission system 100 comprising a multi-phase power transmission line 101, first and second power transmission nodes E1, E2, respectively connected to opposite first and second ends 102, 103 of the power transmission line 101, a local IED (Intelligent Electronic Device) 105, connected to the power transmission line 101 at its first end 102, also denoted the local end, and a remote IED 106, conneted to the power trnsmission line 101 at its second end, also denoted the remote end. Each of the first and second power transmission nodes E1, E2 may comprise a power source, and/or a power load. The power transmission line 101 comprises a communication link 107 arranged for communication between the local IED 105 and the remote IED 106. The below description resides on an example where the multi-phase power transmission line 101 is a three-phase power transmission line. Other numbers of phases are feasible, as understood by the person skilled in the art. The present method is equally applicable on those power transmission lines. Consequently, the power transmission line 101 has three phase conductors, herein denoted phase A, phase B, and phase C. The communication link 107 may be, for example, a wireless communication link.

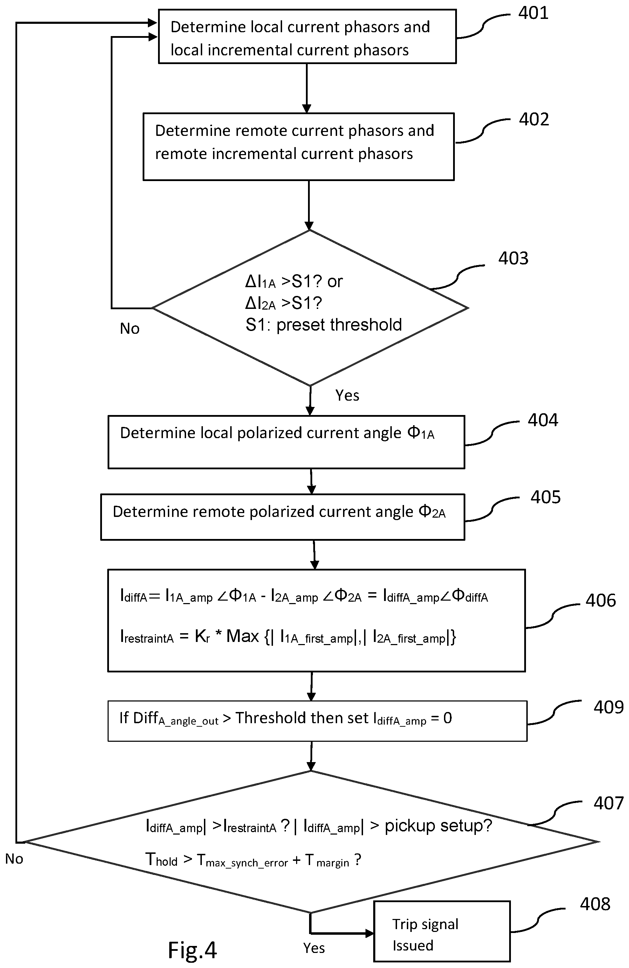

With reference to Fig. 4, according to an embodiment of the present differential protection method it comprises determining 401 first local current phasors I_{1A_first} , I_{1B_first} , I_{1C_first} from local phase currents i₁ₐ, i_{1b}, i_{1c} measured at the local end 102 of the power transmission line 101, and determining 402 first remote current phasors I_{2A_first} , I_{2B_first} , I_{2C_first} from remote phase currents i₂ₐ, i_{2b}, i_{2c} measured at the remote end 103 of the power transmission line 101. As understood by the person skilled in the art, this means that the phase currents i₁ₐ, i_{1b}, i_{1c}, i₂ₐ, i_{2b}, i_{2c} of all three phases A, B, C are measured both by means of the local IED 105 and the remote IED 106, and then they are transformed, typically by means of a DFT (Discrete Fourier Transform), to the corresponding phasors I_{1A_first}, I_{1B_first}, I_{1C_first}, I_{2A_first}, I_{2B_first}, I_{2C_first}. A phasor is a representation consisting of the amplitude and the phase angle of the current, for example, phasor I_{1A_first} is defined as I_{1A_first} = I_{1A_amp}∠Θ_{1A} in phasor form. Here, I_{1A_amp} is the amplitude of the current phasor I_{1A_first} and Θ_{1A} is the phase angle of the current phasor I_{1A_first}.

The method further comprises determining 401 local incremental current phasors ΔI_{1A}, ΔI_{1B}, ΔI_{1C} from the local phase currents i₁ₐ, i_{1b}, i_{1c} and determining 402 remote incremental current phasors ΔI_{2A}, ΔI_{2B}, ΔI_{2C} from the remote phase currents i₂ₐ, i_{2b}, i_{2c}. As also understood by the person skilled in the art, incremental current is meant a current that is determined on basis of the latest and previous current measurements. According to the present method, the incremental currents may be determined by means of an instantaneous value of the current, a value from one time period earlier and a value from two time periods earlier. Here, one time period T is a fundamental power frequency period for the given AC power system. More particularly, preferably the determination is made according to the following equation: ${ΔI}_{1 A} = {i}_{1 a} \left(t\right) - 2 * {i}_{1 a} \left(t-2T\right) + {i}_{1 a} \left(t-T\right)$ (1) Equation (1) is given for phase A, but is used equally for phases B and C. By using current values from both one fundamental power frequency period (T) and two fundamental power frequency periods (2T) back in time, the calculated incremental current is more stable in case of signal distortion due to harmonics and possible power swings in the given AC power system.

The local current phasors and the remote current phasors as well as the local incremental current phasors and the remote incremental current phasors are determined at each respective end 102, 103 before being sent to the other end via the communication link 107.

The method further comprises, for each phase:
- determining 404 a local polarized current phase angle Φ_{1A} as a difference between a phase angle ΔI_{1A_angle} of the local incremental phase current ΔI_{1A} and a phase angle I_{1A_prefault_angle} of a local prefault phase current I_{1A_prefault}, and determining 405 a remote polarized current phase angle Φ_{2A} as a difference between a phase angle ΔI_{2A_angle} of the remote incremental phase current ΔI_{2A} and a phase angle I_{2A_prefault_angle} of a remote prefault phase current I_{2A_prefault}, which may be expressed as: $\begin{matrix}{Φ}_{1 A} = {ΔI}_{1 A _ angle} - {I}_{1 A _ prefault _ angle} \\ {Φ}_{2 A} = {ΔI}_{2 A _ angle} - {I}_{2 A _ prefault _ angle}\end{matrix}$ (2)
- determining 406 a differential current I_{diffA} based on a current difference between a second local current phasor I_{1A_second} and a second remote current phasor I_{2A_second}, wherein the second local current phasor I_{1A_second} is consisting of an amplitude I_{1A_amp} of the first local current phasor I_{1A} and the local polarized current phase angle Φ_{1A}, and wherein the second remote current phasor I_{2A_second} is consisting of an amplitude of the first remote current phasor I_{2A_amp} and the remote polarized current phase angle Φ_{2A}, which may be expressed as: ${I}_{diffA} = {I}_{1 A _ amp} ∠ {Φ}_{1 A} - {I}_{2 A _ amp} ∠ {Φ}_{2 A} = {I}_{diffA _ amp} ∠ {Φ}_{diffA}$ (3)
- and determining 406 a restraint current I_{restraintA} based on a maximum of the absolute values of the amplitude of the first local current phasor I_{1A_first_amp} and the amplitude of the first remote current phasor I_{2A_first_amp}.

More particularly, the restraint current I_{restraintA} may be determined according to: ${I}_{restraintA} = {K}_{r} * Max \left\{\left|{I}_{1 A _ first _ amp}\right|, \left|{I}_{2 A _ first _ amp}\right|\right\}$ (4) where Kᵣ is a coefficient typically used to weight down the current amplitude for the restraint current in order to reduce the risk of falsely not operating. For example, the coefficient Kᵣ may be selected in the range between 0.5 and 0.8.

The prefault phase currents are, as indicated by the term, phase current values that existed before the fault, i.e. the anticipated fault, herein also referred to as a disturbance, occurred.

It should be noted that the above operations of the method being exemplified for phase A are equally performed for the other phases B and C as well. The same is true for the description below, that is operations described for one phase are applied to the other phases as well.

Furthermore, the method comprises determining 407 that a fault condition is true if, for at least one of the three phases A, B, C, the absolute value of the amplitude of the differential current is greater than the restraint current and greater than a pickup setup, that is: $\begin{matrix}\left|{I}_{diffA _ amp}\right| > {I}_{restraintA} \\ \left|{I}_{diffA _ amp}\right| > pickup setup\end{matrix}$ (5) and when the fault condition is true, setting a timeout T_{hold}, checking 407, when the timeout has expired, if the fault condition is still true, and generating, if affirmative, a trip signal 408.

The pickup setup is depending on the demand on sensitivity of line differential protection functions. It may be set by considering the maximum load current level or capacitive charging current level. A simple example can be to set the pickup setup as 1.5 p.u of maximum load current. If the line capacitive charging current is 100 A, the pickup setup can also be given as 250 A as another example.

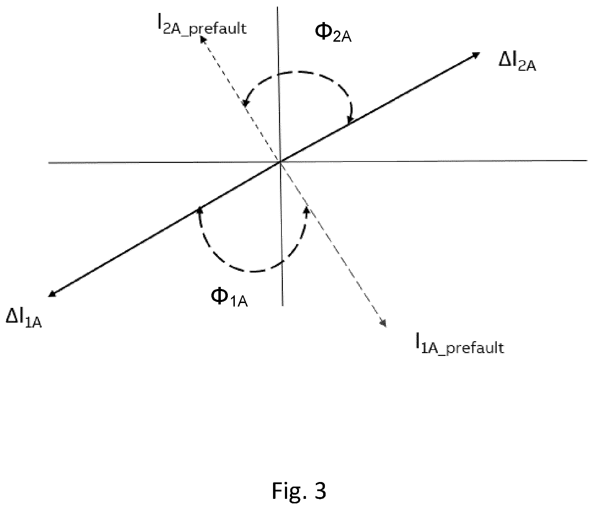

As described above the differential current is, inter alia, related to the local and remote polarized phase angles Φ_{1A} and Φ_{2A}, which in turn are related to the phase angle difference between the phase currents before and after a fault has occurred on the power transmission line 101. When a fault, such as a phase to ground fault, occurs, the phase angles of the phase currents of the faulted phase are shifted. Thereby, the local and remote polarized current phase angles Φ_{1A} and Φ_{2A} become non-zero. As can be seen from the above description this shift is captured by the fault condition in Eqn. (5). More particularly, when the fault is internal, i.e. within the first and second ends 102, 103 of the power transmission line 101 as shown by the F position in Fig. 1, the relation between the local polarized phase angle Φ_{1A} and the remote polarized phase angle Φ_{2A} is in opposite direction such that Φ_{2A} ≈ - Φ_{1A}. On the other hand, if the fault is external, i.e. beyond one or the other end of the power transmission line 101, the relation becomes Φ_{2A} ≈ Φ_{1A}, as illustrated in Figs. 2 and 3 in a phasor diagram. The same type of diagrams can of course be drawn for the other phases too. The situation for an internal fault is shown in Fig. 2, and the situation for an external fault is shown in Fig. 3.

Additionally, if there is a synchronization error on the communication link 107 causing an erroneous decision to generate the trip signal on basis of the fault condition as such, the timeout reduces that risk because the synchronization errors are typically temporary. A common example of a power transmission system with a risk of synchronization errors is an MV power transmission line using wireless communication. The errors are usually caused by temporary disturbances causing a different delay between sending and receiving the current data than the predetermined delay. Wired communication, such as via a fiber optic cable arranged in conjunction with the current conductors, having a very low risk of synchronization errors, is not often used in MV transmission lines. It should be noted, though, that the present disclosure is not limited to MV power transmission lines, but it may be used with any type of power transmission lines where synchronization errors can causer problems.

The timeout T_{hold} may, for example, be determined as the sum of a maximum synchronization error time that is expected to occur, or that has been measured, on the communication link 107, and a time margin, that is: ${T}_{hold} = {T}_{max _ synch _ error} + {T}_{margin}$ (6)

When measuring the currents with the local, and with the remote, IED 105, 106, the IED 105, 106 typically uses a current transformer CT. It may happen that the CT saturates upon the occurrence of a fault on the power transmission line 101. If the fault is external and causes a CT saturation this may cause the operations of the method to end up with generating a trip signal, although that is incorrect. In order to avoid such a risk, the method may further comprise determining 409, for each phase, a phase angle index Diff_{A_angle_out} as a cosine of an absolute value of a difference between the local polarized current phase angle Φ_{1A} and the remote polarized current phase angle Φ_{2A}, and, if the phase angle index is greater than a threshold, setting the differential current I_{diffA} to zero. This may be expressed as: $\begin{matrix}{Diff}_{A _ angle _ out} = cos \left(\left|{Φ}_{1 A}-{Φ}_{2 A}\right|\right) \\ If {Diff}_{A _ angle _ out} > Threshold then {I}_{diffA _ amp} = 0\end{matrix}$ (7)

Here, the threshold can be a positive value range between 0.1-0.25, which is an index for external fault indication even with heavy CT saturation. For internal faults, for example a phase A to ground (AG) fault, with heavy CT saturation in one end (I1A), the given index *Diff_{A_Angle_Out}* Diff_{A_angle_out} is still a negative value. The amplitude of the differential current I_{diffA_amp} is larger than the restraint current I_{restraintA} as given in equation (5) so that the fault in phase A is detected and the trip signal is issued finally. For an external AG fault, as an example, equation (7) is applied as Diff_{A_angle_out} is a positive value which is higher than the threshold, the amplitude of the differential current I_{diffA_amp} is switched to zero before comparing it to the threshold, i.e. before performing eqn. (5), so that there is no incorrect trip during the external AG fault period even for heavy CT saturation conditions.

The method may further comprise a starting operation that is performed before starting to determine the local and remote polarized current phase angles. More particularly, the method comprises detecting 403 an occurrence of a disturbance including comparing at least one of the incremental currents with a preset disturbance threshold S1, and deciding that a disturbance has occurred when one of the incremental currents exceeds the disturbance threshold. The disturbance threshold S1 may be, for example, 0.5 p.u. In other words, as an example for phase A, the disturbance, which can be a true fault, either an internal or an external fault, or other abnormal conditions, may be considered to have occurred if ΔI_{1A} >0.5 p.u, or ΔI_{2A} >0.5 p.u. The local and remote current values that existed just before the disturbance, for example, one or two cycles before the disturbance occurred, are set to be the local prefault phase current I_{1A_prefault} and the remote prefault phase current I_{2A_prefault} mentioned above. While the present disclosure has been illustrated and described in detail in the drawings and foregoing description, such illustration and description are to be considered illustrative or exemplary and not restrictive.

Although features and elements are described above in particular combinations, each feature or element can be used alone without the other features and elements or in various combinations with or without other features and elements.

Other variations to the disclosed embodiments can be understood and effected by those skilled in the art in practicing the present disclosure, from a study of the drawings, the description, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain features are recited in mutually different dependent claims does not indicate that a combination of these features cannot be used to advantage. Any reference signs in the claims should not be construed as limiting the scope.

## Claims

1. A differential protection method for a protected multi-phase power transmission line, the method comprising:
- determining first local current phasors for the phases from local end phase currents measured at a local end of the power transmission line;
- determining first remote current phasors for the phases from remote phase currents measured at a remote end of the power transmission line;
- determining local incremental current phasors for the phases from the local phase currents;
- determining remote incremental current phasors for the phases from the remote phase currents;
for each phase:
- determining a local polarized current phase angle as a difference between a phase angle of the local incremental phase current and a phase angle of a local prefault phase current, and determining a remote polarized current phase angle as a difference between a phase angle of the remote incremental phase current and a phase angle of a remote prefault phase current;
- determining a differential current based on a current difference between a second local current phasor and a second remote current phasor, wherein the second local current phasor is consisting of an amplitude of the first local current phasor and the local polarized current phase angle, and wherein the second remote current phasor is consisting of an amplitude of the first remote current phasor and the remote polarized current phase angle; and
- determining a restraint current based on a maximum of the absolute values of the amplitude of the first local current phasor and the amplitude of the first remote current phasor;
- determining that a fault condition is true if, for at least one of the phases, the absolute value of the amplitude of the differential current is greater than the restraint current and greater than a pickup setup; and
- when the fault condition is true, setting a timeout, checking, when the timeout has expired, if the fault condition is still true, and generating, if affirmative, a trip signal.

2. The differential protection method according to any one of the preceding claims, wherein the timeout is greater than a maximum synchronization error time plus a time margin.

3. The differential protection method according to any one of the preceding claims, comprising determining, before the operation of checking, for each phase, a phase angle index as a cosine of an absolute value of a difference between the local polarized current phase angle and the remote polarized current phase angle, and, if the phase angle index is greater than a threshold, setting the amplitude of the differential current zero.

4. The differential protection method according to any one of the preceding claims, comprising, before performing the operations for each phase, detecting an occurrence of a disturbance including comparing at least one of the incremental currents with a disturbance threshold and deciding that a disturbance has occurred when one of the incremental currents exceeds the disturbance threshold.

5. The differential protection method according to any one of the preceding claims, wherein each of the incremental currents is determined by means of an instantaneous value of the current, a value from one time period earlier and a value from two time periods earlier.

6. The differential protection method according to any one of the preceding claims, comprising receiving, at a local intelligent electronic device, values of the remote incremental phase currents via a communication link.

7. The differential protection method according to claim 6, wherein the remote incremental phase currents have been polarized before being provided to the communication link.

8. The differential protection method according to any one of the preceding claims, wherein the restraint current is determined, for each phase, as a fraction of the maximum of the first local current phasor and the first remote current phasor.
